**Europäisches Patentamt**

**European Patent Office**

**Office européen des brevets**

(19)

(11) Veröffentlichungsnummer : **0 103 690**
**B1**

(12)  **EUROPÄISCHE PATENTSCHRIFT**

(45) Veröffentlichungstag der Patentschrift :
07.05.86

(21) Anmeldenummer : 83106743.4

(22) Anmeldetag : 08.07.83

(51) Int. Cl.⁴ : **H 01 L 21/90, H 01 L 21/314,**
**H 01 L 23/52**

(54)  **Verfahren zum Herstellen einer Isolierschicht zwischen Metallisierungsebenen von integrierten Halbleiterschaltungen.**

(30) Priorität : 29.07.82 DE 3228399

(43) Veröffentlichungstag der Anmeldung :
28.03.84 Patentblatt 84/13

(45) Bekanntmachung des Hinweises auf die Patenterteilung : 07.05.86 Patentblatt 86/19

(84) Benannte Vertragsstaaten :
**AT DE FR GB IT**

(56) Entgegenhaltungen :
**DE-A- 2 355 567**
**DE-A- 3 033 513**
**DE-A- 3 034 900**
**DE-A- 3 114 679**
**DE-B- 2 049 908**
**US-A- 4 105 805**

(73) Patentinhaber : **Siemens Aktiengesellschaft**
**Berlin und München Wittelsbacherplatz 2**
**D-8000 München 2 (DE)**

(72) Erfinder : **Eggers, Harald, Dipl.-Ing.**
**Erich-Kästner-Strasse 19**
**D-8000 München 40 (DE)**

EP 0 103 690 B1

Jouve, 18, rue St-Denis, 75001 Paris, France

## Beschreibung

Die Erfindung betrifft ein Verfahren zum Herstellen einer monolithisch integrierten Schaltung, bei dem die Oberfläche des die pn-Übergänge der Schaltung aufnehmenden und vorzugsweise aus monokristallinem Silicium bestehenden Halbleitersubstrats mit einer $SiO_2$-Schicht versehen und letztere als Träger für eine durch Leitbahnen bzw. durch kapazitiv mit der Oberfläche des Halbleitersubstrats unter Vermittlung der $SiO_2$-Schicht gekoppelten Elektroden gegebene erste Metallisierung verwendet wird, bei dem nach Herstellung der ersten Metallisierung diese mit einer Isolierschicht aus aufgestäubtem $SiO_2$ abgedeckt wird, bei dem nach Fertigstellung der ersten Metallisierung und einer von ihr getragenen Isolierschicht an deren Oberfläche eine zweite Metallisierung aufgebracht wird, die mittels in der genannten Isolierschicht vorgesehenen Ausnehmungen in elektrischen Kontakt mit hierfür vorgesehenen Stellen der ersten Metallisierung gebracht und schließlich ebenfalls zu elektrischen Leitbahnen geformt wird.

Solche Verfahren sind allgemein üblich. Die mit ihrer Hilfe entstandenen integrierten Schaltungen werden als « zwei-lagen-verdrahtete » oder bei Anwendung mehrerer Metallisierungsebenen als « mehr-lagen-verdrahtete » IC's bezeichnet.

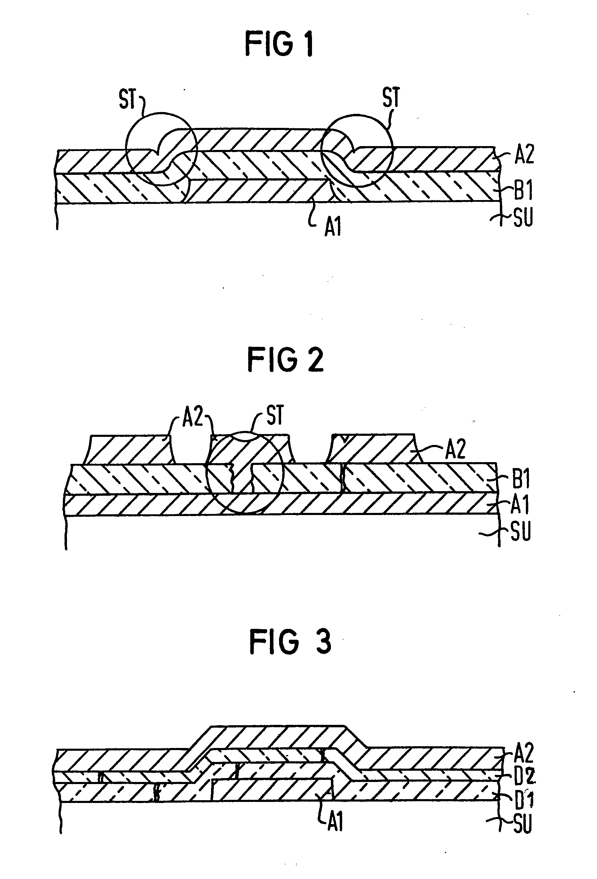

Nun ist bei der fabrikatorischen Herstellung solcher integrierten Schaltungen erfahrungsgemäß die Herstellung der zweiten und weiterer Metallisierungsebenen merklich kritischer als die Herstellung der der Halbleitersubstratoberfläche am nächsten liegenden ersten Metallisierungsebene. Dies zeigt sich darin, daß Ausfälle, die durch Fehler in der Metallisierung bedingt sind, weitaus häufiger in der zweiten Metallisierungsebene und in ggf. vorhandenen weiteren und (mit Ausnahme von beabsichtigten Verbindungsstellen) von einander durch je eine Isolierschicht getrennten Metallisierungsebenen als in der ersten Metallisierungsebene auftreten. Hierfür sind in der Hauptsache zwei Ausfallserscheinungen verantwortlich, die nun anhand der Figuren 1 und 2 deutlich gemacht werden.

Als erste Fehlererscheinung sind Abrisse und die dadurch bedingten Unterbrechungen von Leitbahnen in der zweiten Metallsierungsebene bzw. einer ggf. vorhandenen dritten Metallisierungsebene usw. zu verzeichnen, die an Stellen auftreten, an denen Leitbahnen A2 der zweiten Metallisierungsebene (bzw. einer einen noch größeren Abstand von der Substratoberfläche aufweisenden dritten Metallisierungsebene usw.) eine Leitbahn A1 der ersten Metallisierungsebene (bzw. einer anderen zwischen der betrachteten Metallisierungsebene und der Substratoberflächeangeordneten Metallisierungsebene) überkreuzen.

Die geometrische Situation ist in Figur 1 dargestellt. Die untere Leitbahn A1 wird durch eine dielektrische Zwischenschicht B1 abgedeckt, die den Träger der nächsten Metallisierungsebene und damit einer dieser angehörenden und die untere Leitbahn A1 überkreuzenden Leitbahn A2 bildet. Erfahrungsgemäß kann die Kante der der unteren Metallisierungsebene (also der ersten Metallisierungsebene) angehörenden Leitbahn A1 zu Einschnürungen der (der zweiten Metallisierungsebene angehörenden) überkreuzenden Leitbahn A2 führen, die dann sehr rasch zu einem Ausfall der Leitbahn A2 und damit der integrierten Halbleiterschaltung führen können. In der Figur 1 und in den Figuren 2 und 3 bedeutet SU das mit einer den Träger für die erste Metallisierungsebene bildenden $SiO_2$-Schicht bedeckte Halbleitersubstrat, A1 eine der ersten Metallisierungsebene angehörenden Leitbahn, die zusammen mit den übrigen der ersten Metallisierungsschicht angehörenden Leitbahnen von einer Isolierschicht B1 von den Leitbahnen A2 der zweiten Metallisierungsebene getrennt ist. (vgl. hierzu z. B. « Der Elektroniker, 6-1982, S. 49 » Bild 2.49). Die Leitbahnen bestehen aus einem hierzu gebräuchlichen Metall, insbesondere aus Aluminium, die Isolierschicht B1 z. B. aus $SiO_2$.

Wie nun aus Figur 1 ersichtlich, kann die Kante der der ersten Metallisierungsebene angehörenden Leitbahn zu merklichen Einschnürungen an den darüber liegenden Stellen ST der der zweiten Metallisierungsebene angehörenden, überkreuzenden Leitbahn A2 führen. Diese Einschnürungen der Leitbahn A2 führen dann sehr rasch zu einer Unterbrechung derselben und damit zu ihrem Ausfall, was einen Ausfall der gesamten integrierten Schaltung bedeutet.

Als zweite Fehlerquelle sind Kurzschlüsse zwischen zwei sich überkreuzenden und zwei einander benachbarten Metallisierungsebenen angehörenden Leiterbahnen zu verzeichnen, die durch unbeabsichtigte Löcher und sonstige Defekte der zwischen den beiden Leiterbahnen A1 und A2 vorgesehenen dielektrischen Trennungsschicht bedingt sind.

Als Material für die zwischen den benachbarten Metallisierungsebenen und damit zwischen den beiden Leiterbahnen A1 und A2 vorgesehenen dielektrischen Schicht B1 ist entweder die Anwendung von aufgestäubtem (aufgesputertem) $SiO_2$ oder von sog. Plasmanitrid ($Si_xN_y$) üblich. Die Bezeichnung « Plasmanitrid » besagt, daß diese Schicht mittels einer geeigneten Plasma-Gasentladung aufgebracht worden ist.

Der Vorteil für die Verwendung von aufgesputtertem $SiO_2$ für das Zwischendielektrikum B1 liegt nun darin das aufgesputterte Oxyd die Tendenz zeigt, zu einer Einebnung der Topologie an der Außenseite der Isolierschicht B1 zu führen, womit die Gefahr für die anhand von Figur 1 gezeigte Ausfallserscheinung reduziert wird. Dieser Einebnungseffekt ist aber nicht gegeben, wenn die das Zwischendielektrikum bildende Isolierschicht B1 mittels Plasmaentladung erzeugt und aufgebracht wurde.

Ein wesentlicher Nachteil der Verwendung ei-

ner aufgesputterten SiO$_2$-Schicht für das Zwischendielektrikum B1 ist jedoch darin gegeben, daß in einer solchen Schicht sehr viele Defekte (Pinholes) vorliegen, die dann zu der bereits erwähnten und in Figur 2 dargestellten zweiten Fehlerquelle führen können. Weiter benötigt man lange Ätzzeiten bei der (insbesondere mittels Photolack-Ätztechnik unter Verwendung eines chemischen Ätzmittels oder unter Verwendung von Plasmaätzung vorzunehmenden) Strukturierung der dielektrischen Zwischenschicht B1, die zur Erzeugung der erwähnten Kontaktlöcher zu der ersten Metallisierungsebene (bzw. der Halbleiteroberfläche) dient, falls die dielektrische Zwischenschicht B1 durch Aufsputtern erzeugt worden ist.

Ein Nachteil der Verwendung einer durch Plasmaentladung erzeugten dielektrischen Zwischenschicht B1 ist die Tatsache, daß sich die Kanten der darunter liegenden Metallisierung, also der Leitbahnen A1, unvermindert durch die Zwischenschicht B1 hindurch im Sinne der in Figur 1 dargestellten Fehlerquelle bemerkbar machen, so daß der nachfolgende Metallisierungsprozeß steile Stufen an der Oberfläche der dielektrischen Zwischenschicht B1 zu bedecken hat, was zu einer Verminderung der Ausbeute führt.

Zur Beseitigung der genannten Nachteile schlägt die Erfindung ein Verfahren der eingangs angegebenen Art vor, bei dem erfindungsgemäß die unmittelbar auf die erste Metallisierung aufgebrachte und aus aufgestäubtem (aufgesputtertem) SiO$_2$ bestehende Isolierschicht zunächst mit einer weiteren und unter Anwendung des Plasmaverfahrens erzeugten anorganischen Isolierschicht abgedeckt und dann nach Strukturierung derselben sowie der aufgestäubten SiO$_2$-Schicht auf dieser anorganischen Isolierschicht die zweite Metallisierung aufgebracht und diese in der jeweils erforderlichen Weise geformt wird.

Die unter Anwendung des Plasmaentladeverfahrens aufgebrachte weitere Isolierschicht DE (vgl. Figur 3) kann bei einer ersten Ausführungsform des erfindungsgemäßen Verfahrens ebenfalls aus SiO$_2$ bestehen. Eine andere vorteilhafte Möglichkeit ist durch die Verwendung von Siliciumnitrid als Material für die weitere Isolierschicht D2 zu sehen, während die darunter liegende Isolierschicht D1 in allen Fällen aus aufgesputtertem SiO$_2$ besteht. Eine weitere Möglichkeit für die weitere Isolierschicht D2 wäre die Anwendung von Al$_2$O$_3$. Ersichtlich bilden die beiden Teilschichten. D1 und D2 zusammen eine dielektrische Zwischenschicht, die bezüglich ihrer geometrischen Anordnung der dielektrischen Zwischenschicht B1 entspricht.

Da sich die Tendenz zur Einebnung der Außenfläche einer aufgestäubten SiO$_2$-Schicht sehr rasch auswirkt, genügt es, wenn die Mindeststärke der aufgesputterten Teilschicht D1 etwa 0,6 μm beträgt. Für die durch Plasmaentladung aufgebrachte äußere Teilschicht D2 sollte die Mindeststärke größer sein. Für den Fall, daß die äußere Teilschicht D2 aus SiO$_2$ besteht als auch für den Fall, daß die äußere Teilschicht aus Siliciumnitrid besteht, wird für die äußere Teilschicht eine Mindeststärke von 0,7 μm vorgeschlagen.

Bei Verwendung des erfindungsgemäßen Verfahrens erhält man bezüglich der ersten und der zweiten Metallisierungsebene die aus Figur 3 ersichtliche Struktur, deren Oberfläche ggf. in üblicher Weise mit einer weiteren Isolierschicht (nicht dargestellt) abgedeckt werden kann. Sind noch eine dritte oder gar eine vierte Metallisierungsebene vorgesehen, so ist auch dann zwischen den jeweils benachbarten Metallisierungsebenen jeweils eine aus zwei Teilschichten D1 und D2 bestehende und durch Anwendung des erfindungsgemäßen Verfahrens erzeugten dielektrische Zwischenschicht vorgesehen.

Als Vorteil der Anwendung der Erfindung hat man :

a) eine sehr geringe resultierende Defektdichte der die benachbarten Metallisierungsebenen trennenden dielektrischen Zwischenschicht vor allem dann zu verzeichnen, wenn die obere Teilschicht D2 aus durch Plasmaentladung abgeschiedenen Siliciumnitrid besteht. Die Wahrscheinlichkeit, daß die beiden in unterschiedlicher Weise erzeugten Teilschichten an derselben Stelle einen Pinhole oder einem anderen Defekt versehen sind, der dann zur Entstehung einer unbeabsichtigten leitenden Verbindung zwischen den beiden durch die Isolierschicht D1 + D2 getrennten Metallisierungen A1 und A2 anlaß geben könnten, ist erfahrungsgemäß sehr klein.

b) Da die Teilschicht D1 aus durch Aufsputtern aufgebrachtem SiO$_2$ besteht und der Einebnungseffekt an der Außenseite dieser Teilschicht sich bereits bei sehr geringen Stärken dieser Teilschicht vorteilhaft bemerkbar macht, und außerdem seine nach außen auf die zweite Metallisierung A2 gerichtete vorteilhafte Wirkung durch die Anwesenheit der äußeren Teilschicht D2 trotz deren unterschiedlicher Erzeugungsweise durch Plasmaentladung nicht beeinträchtigt wird, ist eine wesentlich größere Sicherheit gegenüber dem anhand von Figur 1 gezeigten Schaden gewährleistet, als dies bei den in üblicher Weise hergestellten Strukturen der Fall ist.

Dieser Vorteil ist zwar mit einem etwas größeren technischen Aufwand im Vergleich zu dem üblichen Verfahren verbunden ; jedoch rechtfertigt die höhere Ausbeute und Betriebssicherheit der erhaltenen Halbleitervorrichtungen diese Tatsache in vollem Ausmaß. Zudem ist hierzu festzustellen, daß die Gesamtstärke der dielektrischen Zwischenschicht D1 + D2 nicht größer als die Stärke der mit einem homogenen Abscheideverfahren aufgebrachten dielektrischen Zwischenschicht B1 bei den auf übliche Weise hergestellten Anordnungen.

Besonders vorteilhaft erscheint die Anwendung des erfindungsgemäßen Verfahrens, wenn gleichzeitig die Anwendung der in der Literaturstelle « IEEE/ED-28 No. 5 (May 1981) S. 552 beschriebenen sog. « Doppel-Lift-Off-Technologie » gegeben ist.

Zu erwähnen ist schließlich noch, daß die die Leitbahnen A1, A2 bildende und insbesondere aus Aluminium bestehende Metallisierung z. B. durch Aufdampfen oder Aufsputtern aufgebracht werden kann.

## Patentansprüche

1. Verfahren zum Herstellen einer monolithisch integrierten Schaltung, bei dem die Oberfläche des die pn-Übergänge der Schaltung aufnehmenden und vorzugsweise aus monokristallinem Silicium bestehenden Halbleitersubstrats mit einer $SiO_2$-Schicht versehen und letztere als Träger für eine durch leitbahnen bzw. durch kapazitiv mit der Oberfläche des Halbleitersubstrats unter Vermittlung der $SiO_2$-Schicht gekoppelten Elektroden gegebene erste Metallisierung (A1) verwendet wird, bei dem nach der Herstellung der ersten Metallisierung diese mit einer Isolierschicht (D1) aus aufgestäubtem $SiO_2$ abgedeckt wird, bei dem nach Fertigstellung der ersten Metallisierung (A1) und einer von ihr getragenen Isolierschicht an deren Oberfläche eine zweite Metallisierung (A2) aufgebracht wird, die mittels in der genannten Isolierschicht vorgesehenen Ausnehmungen in elektrischen Kontakt mit hierfür vorgesehenen Stellen der ersten Metallisierung gebracht und schließlich ebenfalls zu elektrischen Leitbahnen geformt wird, dadurch gekennzeichnet, daß die unmittelbar auf die erste Metallisierung (A1) aufgebrachte und aus aufgestäubtem $SiO_2$ bestehende Isolierschicht (D1) zunächst mit einer weiteren und unter Anwendung des Plasmaverfahrens erzeugten anorganischen Isolierschicht (D2) abgedeckt und dann nach Strukturierung derselben sowie der aufgestäubten $SiO_2$-Schicht (D1) auf dieser anorganischen Isolierschicht (D2) die zweite Metallisierung (A2) aufgebracht und geformt wird.

2. Verfahren nach Anspruch 1, dadurch gekennzeichnet, daß als Material für die durch Plasmaentladung aufzubringende weitere Isolierschicht (D2) Siliciumnitrid verwendet wird.

3. Verfahren nach Anspruch 1 oder 2, dadurch gekennzeichnet, daß als Material für die durch Plasmaentladung aufzubringende zweite Isolierschicht (D2) Siliciumdioxyd ($SiO_2$) verwendet wird.

4. Verfahren nach Anspruch 2 oder 3, dadurch gekennzeichnet, daß die Stärke der durch Aufstäuben aufzubringenden $SiO_2$-Schicht (D1) auf mindestens 0,6 µm und die Stärke der durch Plasmaentladung aufzubringenden weiteren Isolierschicht (D2) auf mindestens 0,7 µm eingestellt wird.

## Claims

1. A method of producing a monolithic integrated circuit, in which the surface of the semiconductor substrate which accommodates the pn-junctions of the circuit and preferably consists of monocrystalline silicon, is provided with an $SiO_2$-layer and the latter is used as a carrier for a first metallization (Al) which is given by conductor paths or by electrodes which are capacitively coupled to the surface of the semiconductor substrate through the $SiO_2$-layer, wherein, after the production of the first metallization, the latter is covered with an insulating layer (D1) consisting of sprayed $SiO_2$, and wherein after the completion of the first metallization (A1) and an insulating layer carried thereon, the surface of said insulating layer is provided with a second metallization (A2) which by means of openings provided in said insulating layer, is brought into electrical contact with locations of the first metallization which are provided for this purpose, and finally also shaped to form electrical conductor paths, characterised in that the insulating layer (D1) which is directly applied on to the first metallization (A1) and which consists of sprayed $SiO_2$ is first covered with a further inorganic insulating layer (D2), which is produced using the plasma process, and the second metallization (A2) is subsequently applied on to and shaped on the inorganic insulating layer (D2) after the insulating layer (D1) and the sprayed $SiO_2$-layer have been structured.

2. A method as claimed in Claim 1, characterised in that silicon nitride is used as the material for the further insulating layer (D2) which is to be applied by plasma discharge.

3. A method as claimed in Claim 1 or Claim 2, characterised in that silicon dioxide ($SiO_2$) is used as the material for the second insulating layer (D2) which is to be applied by plasma discharge.

4. A method as claimed in Claim 2 or Claim 3, characterised in that the thickness of the $SiO_2$-layer (D1) which is to be applied by spraying is at least 0.6 µm and the thickness of the further insulating layer (D2) which is to be applied by plasma discharge is at least 0.7 µm.

## Revendications

1. Procédé pour fabriquer un circuit intégré monolithiquement, dans lequel la surface du substrat semiconducteur constitué de préférence par du silicium monocristallin et destiné à recevoir les jonctions pn du circuit, est recouverte d'une couche de $SiO_2$ qui est utilisée comme support pour une première couche de métallisation (A1) constituée par des pistes conductrices ou par des électrodes couplées capacitivement avec la surface du substrat semiconducteur à l'aide de la couche de $SiO_2$, dans lequel, après la réalisation de la première métallisation, celle-ci est recouverte d'une couche isolante (D1) formée par du $SiO_2$ déposé par pulvérisation, dans lequel, après réalisation de la première métallisation (A1) et d'une couche isolante portée par cette dernière, on dépose sur la surface de cette couche isolante une seconde métallisation (A2) qui, à l'aide d'ouvertures ménagées dans ladite couche isolante, est amenée en contact électrique avec des emplacements prévus à cet effet, de la première métallisation, et qui est finalement conformée en pistes électriquement conductrices, caractérisé par le fait que la couche isolante (D1) constituée par du $SiO_2$ déposée par pulvérisation et réalisée directement sur la première métallisation (A1), est d'abord recouverte d'une seconde couche isolante anorganique (D2) produite avec mise en œuvre du procédé au plasma, et qu'ensuite, après structuration de ladite seconde couche isolante (D2) et de la couche de $SiO_2$ (D1) obtenue par pulvérisation, on dépose sur cette couche isolante anorganique (D2) la seconde métallisation et on la conforme.

2. Procédé selon la revendication 1, caractérisé par le fait que l'on utilise du nitrure de silicium comme matériau pour la seconde couche isolante (D2) à déposer par décharge dans un plasma.

3. Procédé selon la revendication 1 ou 2, caractérisé par le fait que l'on utilise du dioxyde de silicium ($SiO_2$) comme matériau pour la seconde couche isolante (D2) à déposer par décharge dans un plasma.

4. Procédé selon la revendication 2 ou 3, caractérisé par le fait que l'on règle l'épaisseur de la couche de $SiO_2$ (D1) à déposer par pulvérisation, à au moins 0,6 $\mu$m, et l'épaisseur de la seconde couche isolante (D2) à déposer par décharge dans un plasma, à au moins 0,7 $\mu$m.

# FIG 1

ST

ST

A2

B1

SU

A1

# FIG 2

A2

ST

A2

B1

A1

SU

# FIG 3

A2

D2

D1

A1

SU